(19) **Europäisches Patentamt European Patent Office Office européen des brevets**

(11) **EP 3 063 548 B1**

(12) **FASCICULE DE BREVET EUROPEEN**

(45) Date de publication et mention
de la délivrance du brevet:
**13.12.2017 Bulletin 2017/50**

(51) Int Cl.:
***G01R 31/12*** *(2006.01)*

(21) Numéro de dépôt: **14790613.5**

(22) Date de dépôt: **29.10.2014**

(86) Numéro de dépôt international:
**PCT/EP2014/073251**

(87) Numéro de publication internationale:
**WO 2015/063172 (07.05.2015 Gazette 2015/18)**

(54) **PROCEDE DE DETECTION DE DECHARGE PARTIELLE DANS UN POSTE ELECTRIQUE HAUTE TENSION ISOLE AU GAZ**

VERFAHREN ZUR FESTSTELLUNG VON TEILENTLADUNGEN IN EINER GASISOLIERTEN HOCHSPANNUNGS-UNTERSTATION

METHOD OF DETECTING PARTIAL DISCHARGE IN A GAS INSULATED HIGH VOLTAGE ELECTRICAL SUBSTATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.10.2013 FR 1360730**

(43) Date de publication de la demande:
**07.09.2016 Bulletin 2016/36**

(73) Titulaire: **General Electric Technology GmbH 5400 Baden (CH)**

(72) Inventeurs:
• **PENNING, Jean-François**
  **F-73410 La Biolle (FR)**
• **SARR, Assane**
  **F-38100 Grenoble (FR)**
• **DESRUELLE, Luc**
  **F-73000 Jacob Bellecombette (FR)**

(74) Mandataire: **Cleary, Fidelma et al Global Patent Operation - Europe GE International Inc. The Ark 201 Talgarth Road Hammersmith London W6 8BJ (GB)**

(56) Documents cités:
**EP-A1- 1 484 616     FR-A1- 2 977 322**

• **FRUTH B A ET AL: "Combination of frequency spectrum analysis and partial discharge pattern recording", ELECTRICAL INSULATION, 1994., CONFERENCE RECORD OF THE 1994 IEEE INTER NATIONAL SYMPOSIUM ON PITTSBURGH, PA, USA 5-8 JUNE 1994, NEW YORK, NY, USA,IEEE, 5 juin 1994 (1994-06-05), pages 296-300, XP010139506, DOI: 10.1109/ELINSL.1994.401508 ISBN: 978-0-7803-1942-4**

EP 3 063 548 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

Domaine technique et art antérieur

La présente invention concerne un procédé de détection de décharge partielle dans un poste électrique haute tension isolé au gaz.

Différentes techniques sont connues de l'art antérieur pour détecter des décharges partielles qui surviennent à l'intérieur d'un matériel haute tension.

Une des techniques connues consiste à détecter les décharges partielles à l'aide de détecteurs UHF (UHF pour « Ultra Haute Fréquence »). Un problème rencontré avec les détecteurs UHF est cependant leur aptitude à détecter également les ondes électromagnétiques présentes à l'extérieur du matériel haute tension.

En effet, en même temps qu'ils détectent les ondes électromagnétiques générées par les décharges partielles à l'intérieur du matériel haute tension, les détecteurs UHF détectent également les ondes électromagnétiques présentes à l'extérieur du matériel. Les ondes électromagnétiques présentes à l'extérieur du matériel sont générées par d'autres sources que les décharges partielles et pénètrent dans le matériel haute tension par différentes ouvertures (brides des enveloppes, hublots de sectionneurs, traversées aériennes, etc.).

Ces ondes électromagnétiques externes peuvent avoir une répartition analogue à celle des signaux émis par les décharges partielles et risquent, en conséquence, d'être interprétées comme la présence de décharges partielles. Comme les détecteurs UHF génèrent habituellement des alarmes basées sur un dépassement de seuil en amplitude, des alarmes intempestives peuvent être générées du fait de la détection de ces bruits externes.

Une réjection fiable des bruits externes est donc nécessaire pour éviter de les confondre avec les signaux émis par des décharges partielles.

Pour effectuer cette réjection, il est connu des systèmes de détection qui effectuent une soustraction des signaux détectés par les détecteurs UHF internes au matériel haute tension avec un signal détecté par un détecteur externe au matériel.

D'autres systèmes de détection font une analyse de coïncidence en comparant les signaux détectés par les détecteurs internes au matériel haute tension. Dans le cas où il n'y a de signal que sur une seule phase des trois phases d'un matériel haute tension, une alarme est déclenchée. Dans le cas où il y a des signaux sur deux ou trois phases, l'alarme n'est pas déclenchée, car on considère alors que les signaux viennent de l'extérieur et ont pénétré dans le matériel haute tension avant d'être détectés par les détecteurs internes.

Les systèmes qui utilisent le principe de la soustraction font une simple soustraction du signal qui ne prend pas en compte le fait que la perméabilité du matériel haute tension aux ondes électromagnétiques UHF n'est pas totale, mais qu'elle varie en fonction de la fréquence. De ce fait, la soustraction risque d'enlever trop de signal utile et même de masquer complètement les signaux émis par les décharges partielles.

Les systèmes qui utilisent l'analyse de coïncidence présentent l'inconvénient de ne pas déclencher d'alarme lorsque des décharges partielles surviennent sur les trois phases. Les concepteurs de ces systèmes argumentent sur le fait que l'occurrence de décharges partielles sur plusieurs phases à la fois et au même endroit a une probabilité très faible.

Cet argument n'est, en fait, pas exact. En effet, par exemple, dans un disjoncteur haute tension, les mouvements rapides et brusques de certaines pièces engendrent des frottements entre ces pièces, générant ainsi des particules métalliques dans les trois phases de l'appareil. Il en résulte l'apparition de décharges partielles sur les trois phases.

Il est également connu de l'art antérieur la demande de brevet français intitulée « Procédé et dispositif de contrôle d'un poste électrique haute tension au gaz », déposée au nom de la Demanderesse le 30 Juin 2011 et publiée sous le numéro FR 2 977 322.

La demande de brevet FR 2 977 322 divulgue un procédé de détection de décharge partielle dans un matériel haute tension. Le procédé divulgué comprend :

- l'acquisition d'un premier spectre de fréquence des signaux reçus par un capteur UHF interne au matériel haute tension et un deuxième spectre de fréquence des signaux reçus par un capteur UHF externe au matériel haute tension,
- le calcul d'un spectre de fréquence du rapport signal sur bruit à partir du premier spectre de fréquence et du deuxième spectre de fréquence, le premier spectre de fréquence correspondant au signal et le deuxième spectre de fréquence correspondant au bruit,
- la détermination de la présence d'un maximum du spectre de fréquence du rapport signal sur bruit comme signature de la présence d'une décharge partielle,
- l'acquisition temporelle du signal à la même fréquence que le maximum, et
- la superposition des signaux temporels acquis à la fréquence à laquelle le rapport signal/bruit maximum a été déterminé à une courbe de référence représentative de la haute tension présente dans le matériel haute tension.

La détermination de la présence d'une décharge partielle sur la base de la présence d'un maximum du rapport signal sur bruit des spectres de fréquence présente l'inconvénient de nécessiter une intervention humaine et est adaptée à un appareil de détection portatif, utilisé par un opérateur humain.

Le procédé de l'invention ne présente pas les inconvénients mentionnés ci-dessus.

Exposé de l'invention

En effet, l'invention concerne un procédé de détection de décharge partielle dans un poste électrique isolé au gaz, dans lequel au moins un capteur UHF interne audit poste détecte des signaux électromagnétiques et au moins un capteur UHF externe audit poste détecte des signaux électromagnétiques, le procédé comprenant une étape d'acquisition qui mesure, sur une bande de fréquences, un spectre de fréquence des signaux électromagnétiques détectés par le capteur interne et un spectre de fréquence des signaux détectés par le capteur externe et une première étape de calcul qui calcule un spectre de fréquence d'un rapport entre le spectre de fréquence des signaux électromagnétiques détectés par le capteur interne et le spectre de fréquence des signaux détectés par le capteur externe. Le procédé comprend en outre :

- entre l'étape d'acquisition et la première étape de calcul, une étape intermédiaire qui calcule une moyenne et/ou une variance du spectre de fréquence des signaux électromagnétiques détectés par le capteur interne, la première étape de calcul n'étant mise en oeuvre que si ladite moyenne et/ou ladite variance sont respectivement supérieurs ou égaux à un seuil de moyenne et/ou à un seuil de variance,
- une deuxième étape de calcul qui calcule une densité du spectre de fréquence dudit rapport qui succède à la première étape de calcul,
- une étape de comparaison de ladite densité avec un seuil de densité prédéterminé, et
- une étape de génération de signal d'alarme dès lors que ladite densité est supérieure ou égale au seuil de densité prédéterminé.

Selon une caractéristique supplémentaire du procédé de l'invention, l'étape d'acquisition est cyclique.

Selon une autre caractéristique supplémentaire du procédé de l'invention, le cycle de la première étape de calcul est interrompu dès lors que la première étape de calcul est mise en oeuvre, ledit cycle étant maintenu lorsque ladite moyenne et ladite variance sont inférieurs respectivement au seuil de moyenne et au seuil de variance.

Selon encore une autre caractéristique supplémentaire du procédé de l'invention, le cycle de l'étape d'acquisition reprend dès lors que ladite densité est inférieure au seuil de densité prédéterminé.

Selon encore une autre caractéristique supplémentaire du procédé de l'invention, dès lors qu'un signal d'alarme est généré, une étape de détermination du type de décharge partielle est mise en oeuvre.

Selon encore une autre caractéristique supplémentaire du procédé de l'invention, l'étape de détermination du type de décharge partielle comprend une étape de recherche de fréquence pour laquelle ledit rapport est maximum et, dès lors qu'est identifiée la fréquence à laquelle ledit rapport est maximum :

- une acquisition temporelle des signaux délivrés par le capteur UHF interne est mise en oeuvre à la fréquence à laquelle ledit rapport est maximum, et
- les signaux temporels acquis à l'étape d'acquisition temporelle sont superposés à une tension de référence représentative d'une haute tension présente dans le poste électrique isolé au gaz.

Selon encore une autre caractéristique supplémentaire du procédé de l'invention, la bande de fréquences sur laquelle sont calculés le spectre de fréquence des signaux électromagnétiques détectés par le capteur interne et le spectre de fréquence des signaux détectés par le capteur externe peut être comprise entre 100 MHz et 3GHz.

La présente invention est basée sur un procédé d'analyse fréquentielle comparative entre les signaux détectés par des capteurs implantés sur au moins une phase d'un matériel haute tension et les signaux détectés par au moins un capteur externe au matériel haute tension.

En cas d'apparition de signaux sur l'une des phases du matériel haute tension, la courbe spectrale du rapport signal/bruit est calculée sur une bande de fréquences donnée. La surface de cette courbe spectrale est ensuite calculée sur cette même bande de fréquences et on obtient ainsi ce que l'on appelle la densité du rapport signal/bruit. Si cette densité dépasse un certain seuil de densité prédéterminé, on considère que les signaux détectés ne viennent pas de l'extérieur mais d'une décharge partielle survenue à l'intérieur du matériel haute tension.

Le rapport signal/bruit est l'image des signaux présents dans le poste haute tension (et non à l'extérieur), donc des signaux susceptibles d'être des signaux générés par des décharges partielles.

L'énergie du rapport signal/bruit (aire de la courbe) présente donc l'avantage de différencier un rapport signal/bruit riche en bruit d'un rapport signal/bruit pauvre en bruit.

Le procédé de l'invention permet avantageusement de discriminer de façon fiable, sans perte d'information, les bruits externes des signaux émis par de vraies décharges partielles qui surviennent dans le matériel haute tension.

Brève description des figures

D'autres caractéristiques et avantages de l'invention apparaîtront à la lecture d'un mode de réalisation préférentiel décrit en référence aux figures jointes, parmi lesquelles :

- La figure 1 représente un schéma de principe du procédé de détection de décharge partielle de l'invention;
- Les figures 2a-2c représentent des courbes de spectre calculées dans le cadre du procédé de détection de l'invention représenté en figure 1;
- La figure 3 représente une courbe de densité de rapport signal sur bruit calculée dans le cadre du procédé de détection de l'invention représenté en figure 1;
- La figure 4 représente un perfectionnement du procédé de l'invention représenté en figure 1 ;
- Les figures 5a et 5b représentent, respectivement, une courbe de spectre de rapport signal sur bruit et une courbe d'acquisition de signature temporelle associée à la courbe de spectre de rapport signal sur bruit, utilisées dans le cadre du perfectionnement représenté en figure 4 ; et
- La figure 6 représente un exemple de dispositif apte à mettre en oeuvre le procédé de détection de décharge partielle de l'invention.

Exposé détaillé d'un mode de réalisation particulier de l'invention

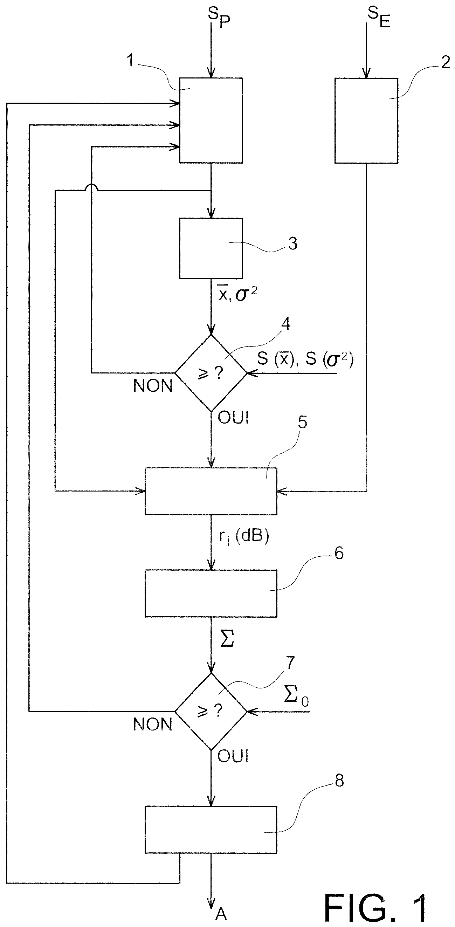

La figure 1 représente un schéma de principe du procédé de détection de décharge partielle de l'invention.

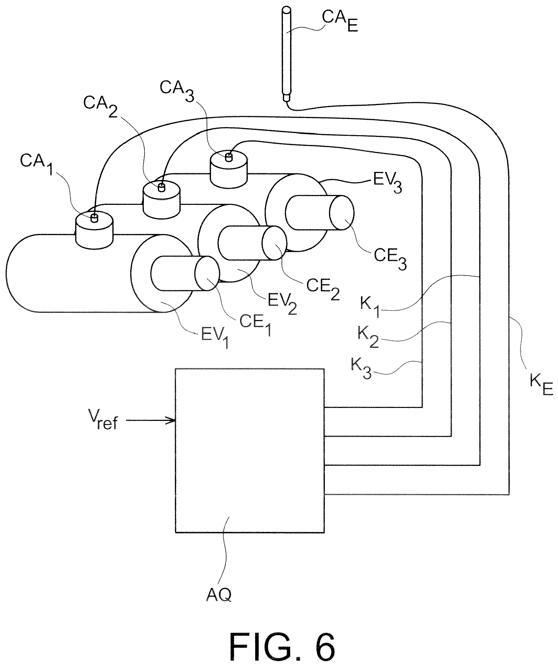

Le procédé représenté en figure 1 est décrit en référence à la détection d'ondes électromagnétiques sur une seule phase d'un appareillage haute tension. Un signal $S_P$ est délivré par un détecteur UHF placé sur une phase de l'appareillage. De façon plus générale, cependant, le procédé de l'invention concerne les trois phases d'un appareillage haute tension, un détecteur UHF étant alors placé sur chacune des phases de l'appareillage haute tension (cf., par exemple, le dispositif de la figure 6).

Le procédé commence par une étape d'acquisition cyclique durant laquelle sont mesurés, simultanément, le spectre de fréquence du signal $S_P$ détecté par le détecteur placé à l'intérieur du matériel haute tension (étape 1) et le spectre de fréquence du signal SE détecté par le détecteur placé à l'extérieur du matériel haute tension (étape 2). La plage de fréquences sur laquelle sont mesurés les spectres de fréquence est préférentiellement comprise entre 100MHz et 3GHz, par exemple, 300MHz et 1200MHz.

La moyenne x et la variance $\sigma^2$ des spectres de fréquence associés au signal $S_P$ sont ensuite calculés (étape 3). Il vient :

$$\bar{x} = \frac{1}{N} \sum_{i=1}^{N} x_i$$

$$\sigma^2 = \frac{1}{N} \sum_{i=1}^{N} (x_i - \bar{x})^2$$

Où $x_i$ est la $i^{eme}$ valeur du spectre (composé de N valeurs associées chacune à une fréquence).

De façon cyclique également, la moyenne $\bar{x}$ et la variance $\sigma^2$ sont comparés à des seuils respectifs $S(\bar{x})$ et $S(\sigma^2)$ (étape 4). Tant que la moyenne $\bar{x}$ et la variance $\sigma^2$ restent inférieurs aux seuils respectifs $S(\bar{x})$ et $S(\sigma^2)$, les spectres sont mesurés de manière cyclique.

En cas de détection d'un signal significatif sur le détecteur situé à l'intérieur du matériel haute tension, la moyenne et/ou la variance du spectre augmente de façon significative et il y a alors dépassement de seuil en moyenne et/ou en variance. Dans ce cas (dépassement de seuil en moyenne et/ou en variance), le procédé de l'invention passe en mode de traitement. Une étape 5 de calcul de la courbe spectrale du rapport signal/bruit est alors mise en oeuvre.

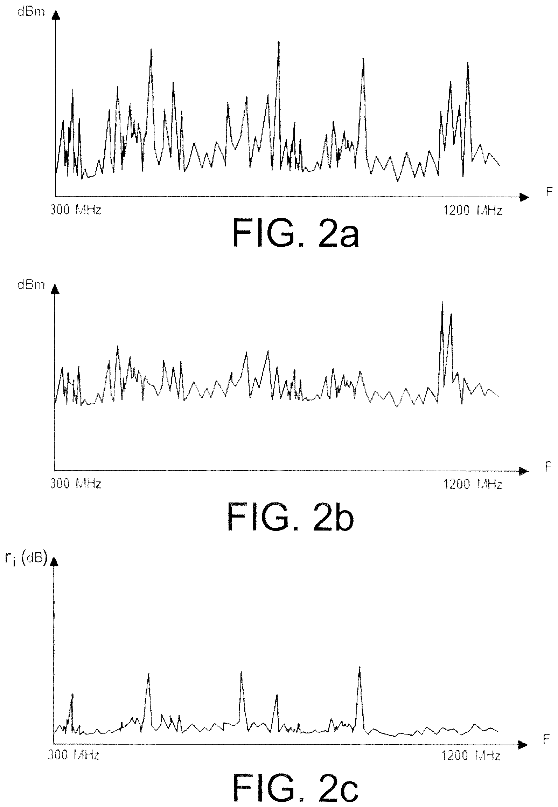

A l'étape 5, le spectre de fréquence du rapport signal sur bruit $S_P/S_E$ est calculé. Les figures 2a et 2b illustrent respectivement, à titre d'exemple, la courbe spectrale du signal $S_P$ et la courbe spectrale du signal $S_E$. L'ordonnée de chaque courbe est exprimée en dBm qui a pour valeur, par définition, le logarithme de la puissance mesurée.

Pour le détecteur interne, il vient :

$$x_i(\text{dBm}) = 10 \log \frac{P_i \ (mW)}{1 \ mW}$$

Où $x_i$ est la $i^{eme}$ valeur du spectre, exprimée en dBm, des signaux détectés par le détecteur interne, et

$P_i$ est la $i^{eme}$ valeur du spectre, exprimée en mW, des signaux détectés par le détecteur interne.

Chaque spectre est composé de N valeurs associées chacune à une fréquence.

De même, il vient pour le détecteur externe :

$$e_i(\text{dBm}) = 10 \log \frac{Pe_i \ (mW)}{1 \ mW}$$

Où $e_i$ est la $i^{eme}$ valeur du spectre, exprimée en dBm, des signaux détectés par le détecteur externe, et

$Pe_i$ est la $i^{eme}$ valeur du spectre, exprimée en mW, des signaux détectés par le détecteur externe.

Chaque spectre est également composé de N valeurs associées chacune à une fréquence.

Le rapport signal/bruit $r_i$ est exprimé dB. Il vient :

$$r_i(\text{dB}) = 10 \log R_i \ (mW) = 10 \log \frac{P_i \ (mW)}{Pe_i \ (mW)}$$

où $R_i$ est la $i^{eme}$ valeur du spectre de rapport signal bruit exprimée en mW,

$P_i$ est la $i^{eme}$ valeur du spectre des signaux du capteur interne exprimée en mW, et

$Pe_i$ est la $i^{eme}$ valeur du spectre des signaux du capteur externe exprimée en mW.

Il vient :

$$r_i(\text{dB}) = x_i(\text{dBm}) - e_i(\text{dBm})$$

La courbe spectrale du rapport signal/bruit $r_i(\text{dB})$ est représentée en figure 2c.

Une variante du procédé décrit ci-dessus consiste à pondérer le signal de bruit venant du capteur externe par un coefficient dit de perméabilité $k_i$ variant avec la fréquence. Il vient :

$$r_i \ (\text{dB}) = x_i \ (\text{dBm}) - k_i \times e_i \ (\text{dBm})$$

Cela permet de tenir compte du fait que les signaux de bruit venant de l'extérieur du matériel haute tension sont atténués de façon non identique en fonction de la fréquence quand ils pénètrent dans le matériel.

Le coefficient de perméabilité $k_i$ est déterminé expérimentalement par des essais sur des éléments typiques du matériel haute tension.

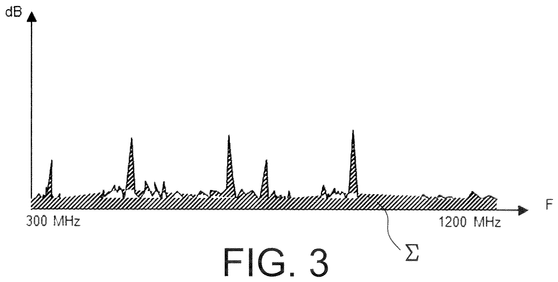

A l'étape 5 de calcul de la courbe spectrale du rapport signal/bruit succède une étape 6 de calcul de la surface définie par cette courbe (cf. Figure 3). La surface ainsi calculée représente la densité du rapport signal/bruit. La densité du rapport signal/bruit ainsi calculée est alors comparée à un seuil de densité prédéterminé (étape 7). Si la densité calculée est inférieure au seuil de densité prédéterminé, il est considéré qu'aucune décharge partielle n'a été détectée par le détecteur interne et les mesures cycliques de spectres sont relancées.

Si la densité calculée est supérieure ou égale au seuil de densité prédéterminé, il est considéré qu'une grande partie de l'énergie des signaux détectés ne provient pas de l'extérieur, mais provient d'une décharge partielle survenue à l'intérieur du matériel haute tension. Un dispositif de génération d'alarme 8 génère une alors une alarme A et le cycle de mesure de spectres reprend.

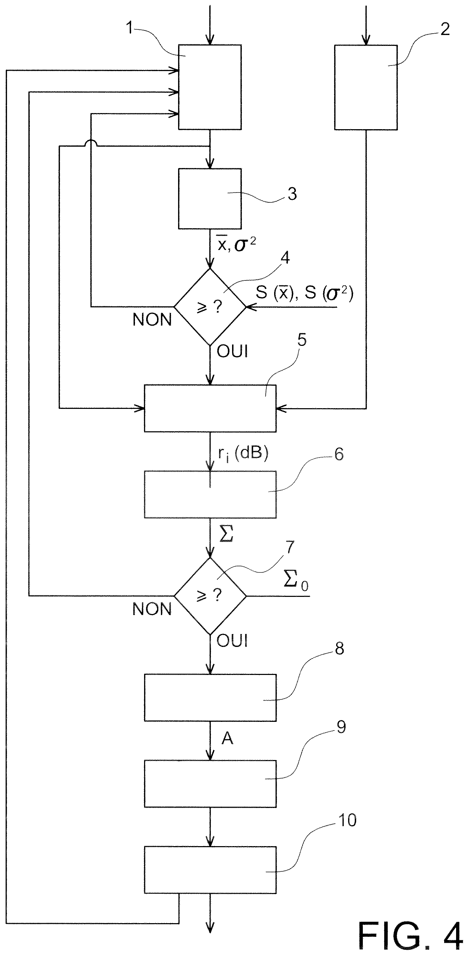

La figure 4 représente un perfectionnement du procédé de l'invention représenté en figure 1.

En plus des étapes 1-8 mentionnées précédemment en référence à la figure 1, le perfectionnement du procédé de l'invention comprend des étapes 9 et 10 aptes à déterminer le type de décharge partielle qui est survient (signature). Le déclenchement du signal d'alarme s'accompagne alors d'une étape 9 de recherche de la fréquence pour laquelle le rapport signal/bruit est maximum. Dès lors que la fréquence pour laquelle le rapport signal/bruit maximum est identifié, le système d'acquisition se place en mode temporel sur cette fréquence. A l'étape 10 qui succède à l'étape 9, les signaux temporels qui surviennent à la fréquence à laquelle le rapport signal/bruit maximum a été déterminé sont enregistrés et superposés à une courbe de référence représentative de la haute tension présente dans le poste électrique. La courbe de référence est formée à partir de mesures de tension prélevées, par exemple, sur un transformateur inductif du poste électrique, un capteur capacitif du poste électrique ou une alimentation basse tension de sous-station du poste électrique. Les signaux temporels superposés à la courbe de référence sont des impulsions électriques qui représentent les décharges partielles.

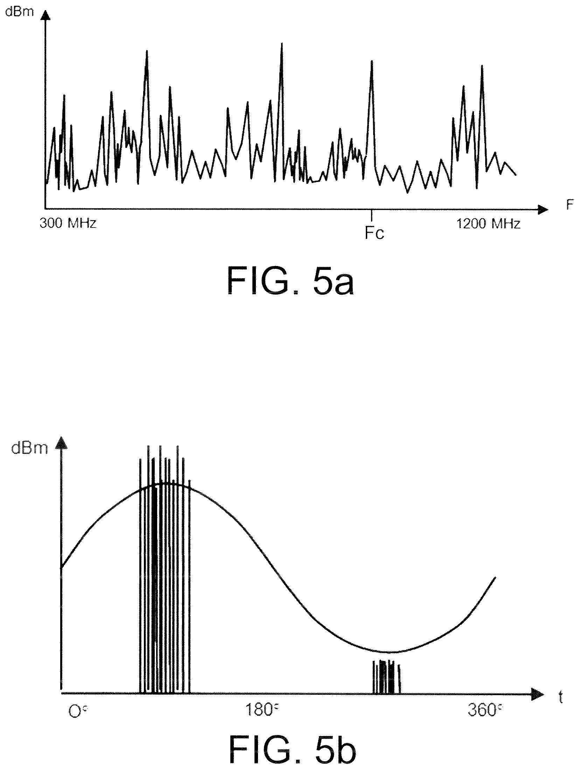

La figure 5a représente un exemple de courbe de spectre de fréquence de rapport signal sur bruit sur laquelle est identifiée la fréquence $F_C$ à laquelle le rapport signal sur bruit est maximum. La figure 5b illustre, à titre d'exemple, la superposition d'impulsions électriques sur une courbe de référence. De façon connue en soi, c'est la répartition des impulsions électriques sur la courbe de référence qui permet d'identifier la nature des décharges partielles.

Une fois la nature des décharges partielles identifiée, le système revient en mode cyclique de mesures de spectres (étapes 1 et 2).

La figure 6 représente un exemple de dispositif de détection de décharge partielle apte à mettre en oeuvre le procédé de l'invention.

Le dispositif comprend des capteurs UHF internes au matériel haute tension $CA_1$, $CA_2$, $CA_3$, un capteur UHF externe au matériel haute tension $CA_E$, des câbles de connexion $K_1$, $K_2$, $K_3$, $K_E$ et un dispositif d'acquisition et de traitement AQ. Les câbles de connexion $K_1$, $K_2$, $K_3$, $K_E$ relient les capteurs respectifs $CA_1$, $CA_2$, $CA_3$, $CA_E$ au dispositif d'acquisition et de traitement AQ.

A titre d'exemple non limitatif, le matériel haute tension sur lequel sont faites les mesures de détection de décharge partielle est constitué de trois conducteurs électriques $CE_1$, $CE_2$, $CE_3$ conduisant chacun le courant d'une phase d'une tension triphasée. Chaque conducteur électrique $CE_i$ (i=1, 2, 3) est entouré d'une enveloppe $EV_i$ contenant un gaz isolant. Pour la mise en oeuvre du perfectionnement de l'invention, une tension de référence en phase ou présentant un déphasage constant avec la haute tension du poste électrique est transmise au dispositif d'acquisition et de traitement AQ. Comme mentionné précédemment, la tension $V_{ref}$ est formée à partir d'une tension prélevée, de façon connue en soi, par exemple, sur un transformateur inductif du poste électrique, sur un capteur capacitif du poste électrique ou une alimentation basse tension d'une sous-station du poste électrique obtenue par sous-tirage de la haute tension du poste.

Selon le mode de réalisation de l'invention représenté sur la figure 6, le dispositif de détection de décharge partielle de l'invention comprend un seul capteur UHF externe $CA_E$. Ce mode de réalisation est particulièrement bien adapté au cas où le bruit externe est uniforme. Selon d'autres modes de réalisation de l'invention, dans le cas où le bruit externe n'est pas uniforme, plusieurs capteurs externes sont préférentiellement utilisés.

Les capteurs $CA_1$, $CA_2$, $CA_3$, $CA_E$ sont, par exemple, des antennes monopoles ou des antennes dipoles.

Le dispositif d'acquisition et de traitement de l'invention comprend des moyens aptes à mettre en oeuvre les étapes 1-8 du procédé de l'invention. Selon le perfectionnement de l'invention, le dispositif AQ comprend, en plus des moyens aptes à mettre en oeuvre les étapes 1-8, des moyens aptes à mettre en oeuvre les étapes 9 et 10.

Le dispositif AQ comprend ainsi :

- des moyens, par exemple un tuner hétérodyne, pour mesurer les signaux délivrés par au moins capteur interne au matériel haute tension et au moins un capteur externe au matériel haute tension sur une bande de fréquence étroite centrée sur une fréquence centrale, la bande de fréquence étroite étant égale, par exemple, à 3MHz ;
- des moyens, par exemple un tuner hétérodyne, pour faire varier la fréquence centrale et mesurer les spectres de fréquence des signaux;
- des moyens, par exemple un ordinateur, pour calculer la moyenne et la variance des spectres de fréquence calculés qui correspondent aux capteurs internes ;
- des moyens, par exemple un ordinateur, pour comparer la moyenne et la variance ainsi calculés à des seuils respectifs de moyenne et de variance et pour générer un signal de détection d'événement dès lors que la moyenne et/ou la variance est supérieure ou égale, respectivement, au seuil de moyenne et/ou de variance ;
- des moyens, par exemple un ordinateur, pour calculer le spectre de fréquence du rapport signal sur bruit associé à chaque capteur interne pour lequel un spectre de fréquence a été calculé, dès lors qu'un signal de détection d'événement est généré ;
- des moyens, par exemple un ordinateur, pour calculer la densité de chaque spectre de fréquence de rapport signal sur bruit calculé ;
- des moyens, par exemple un ordinateur, pour comparer les densités calculées des spectres de fréquence de rapport signal sur bruit à un seuil de densité ; et
- des moyens, par exemple un ordinateur, pour générer une alarme A qui informe de la présence de décharges partielles à l'intérieur du matériel haute tension dès lors que la densité calculée du spectre de fréquence du rapport signal sur bruit associée à un capteur interne du matériel haute tension est supérieure au seuil de densité.

Selon le perfectionnement de l'invention, le dispositif d'acquisition et de traitement comprend, en outre, des moyens pour déterminer le type de décharges partielles qui surviennent dans le matériel haute tension. Les moyens pour déterminer le type de décharge partielle comprennent :

- des moyens, par exemple un ordinateur, pour identifier la fréquence pour laquelle le rapport signal sur bruit associé à chaque capteur interne au matériel haute tension est maximum ;
- des moyens, par exemple un tuner hétérodyne, pour acquérir en mode temporel, à la fréquence pour laquelle le rapport signal sur bruit associé à un capteur interne au matériel haute tension est maximum, les signaux délivrés par le capteur ; et
- des moyens, par exemple un ordinateur, pour superposer à une tension de référence les signaux délivrés en mode temporel par chaque capteur.

Le type de décharge partielle qui est survenu dans le poste électrique est déduit de la localisation des signaux temporels sur la tension de référence.

## Revendications

1. Procédé de détection de décharge partielle dans un poste électrique isolé au gaz, dans lequel au moins un capteur UHF interne audit poste détecte des signaux électromagnétiques ($S_P$) et au moins un capteur UHF externe audit poste détecte des signaux électromagnétiques (SE), le procédé comprenant une étape d'acquisition (1, 2) qui mesure, sur une bande de fréquences, un spectre de fréquence des signaux électromagnétiques détectés par le capteur interne et un spectre de fréquence des signaux détectés par le capteur externe et une première étape de calcul (5) qui calcule un spectre de fréquence d'un rapport entre le spectre de fréquence des signaux électromagnétiques détectés par le capteur interne et le spectre de fréquence des signaux détectés par le capteur externe, **caractérisé en ce qu'**il comprend :

   - entre l'étape d'acquisition (1, 2) et la première étape de calcul (5), une étape intermédiaire (3) qui calcule une moyenne et/ou une variance du spectre de fréquence des signaux électromagnétiques détectés par le capteur interne, la première étape de calcul (5) n'étant mise en oeuvre que si ladite moyenne et/ou ladite variance sont respectivement supérieurs ou égaux à un seuil de moyenne et/ou à un seuil de variance,
   - une deuxième étape de calcul (6) qui calcule une densité du spectre de fréquence dudit rapport qui succède à la première étape de calcul (5),
   - une étape de comparaison (7) de ladite densité avec un seuil de densité prédéterminé, et
   - une étape de génération de signal d'alarme (8) dès lors que ladite densité est supérieure ou égale au seuil de densité prédéterminé.

2. Procédé selon la revendication 1, dans lequel l'étape d'acquisition (1, 2) est une étape cyclique.

3. Procédé selon la revendication 2, dans lequel le cycle de l'étape d'acquisition (1, 2) est interrompu dès lors que la première étape (5) de calcul est mise en oeuvre, ledit cycle étant maintenu lorsque ladite moyenne et ladite variance sont inférieurs respectivement au seuil de moyenne et au seuil de variance.

4. Procédé selon la revendication 2 ou 3, dans lequel le cycle de l'étape d'acquisition (1, 2) reprend dès lors que ladite densité est inférieure au seuil de densité prédéterminé.

5. Procédé selon l'une quelconque des revendications précédentes, dans lequel, dès lors qu'un signal d'alarme (A) est généré, une étape (9, 10) de détermination du type de décharge partielle est mise en oeuvre.

6. Procédé selon la revendication 1, dans lequel l'étape (9, 10) de détermination du type de décharge partielle comprend une étape (9) de recherche de fréquence pour laquelle ledit rapport est maximum et, dès lors qu'est identifiée la fréquence à laquelle ledit rapport est maximum :

   - une acquisition temporelle des signaux délivrés par le capteur UHF interne est mise en oeuvre à la fréquence à laquelle ledit rapport est maximum, et
   - les signaux temporels acquis à l'étape d'acquisition temporelle sont superposés à une tension de référence

($V_{ref}$) représentative d'une haute tension présente dans le poste électrique isolé au gaz.

7. Procédé selon l'une quelconque des revendications précédentes, dans lequel la bande de fréquences sur laquelle sont calculés le spectre de fréquence des signaux électromagnétiques détectés par le capteur interne et le spectre de fréquence des signaux détectés par le capteur externe est comprise entre 100MHz et 3GHz.

**Patentansprüche**

1. Verfahren zur Detektion einer teilweisen Entladung in einer gasisolierten elektrischen Schaltanlage, wobei mindestens ein UHF-Sensor innerhalb der Schaltanlage elektromagnetische Signale ($S_P$) detektiert, und mindestens ein UHF-Sensor außerhalb der Schaltanlage elektromagnetische Signale ($S_E$) detektiert, wobei das Verfahren umfasst: einen Schritt (1, 2) des Erfassens, der, auf einem Frequenzband, ein Frequenzspektrum der elektromagnetischen Signale, die von dem inneren Sensor detektiert werden, und ein Frequenzspektrum der Signale, die von dem äußeren Sensor detektiert werden, misst, und einen ersten Schritt (5) des Berechnens, der ein Frequenzspektrum eines Verhältnisses zwischen dem Frequenzspektrum der elektromagnetischen Signale, die von dem inneren Sensor detektiert werden, und dem Frequenzspektrum der Signale, die von dem äußeren Sensor detektiert werden, berechnet, **dadurch gekennzeichnet, dass** dieses umfasst:

   - zwischen dem Erfassungsschritt (1, 2) und dem ersten Berechnungsschritt (5), einen Zwischenschritt (3), der einen Mittelwert und/oder eine Varianz des Frequenzspektrums der elektromagnetischen Signale, die von dem inneren Sensor detektiert werden, berechnet, wobei der erste Berechnungsschritt (5) nur durchgeführt wird, wenn der Mittelwert und/oder die Varianz jeweils größer oder gleich einer Schwelle des Mittelwerts und/oder einer Schwelle der Varianz sind,
   - einen zweiten Berechnungsschritt (6), der eine Dichte des Frequenzspektrums des Verhältnisses berechnet, der auf den ersten Berechnungsschritt (5) folgt,
   - einen Vergleichsschritt (7) der Dichte mit einer vorherbestimmten Dichteschwelle, und
   - einen Schritt (8) des Generierens eines Alarmsignals, wenn die Dichte größer oder gleich der vorherbestimmten Dichteschwelle ist.

2. Verfahren nach Anspruch 1, wobei der Erfassungsschritt (1, 2) ein zyklischer Schritt ist.

3. Verfahren nach Anspruch 2, wobei der Zyklus des Erfassungsschritts (1, 2) unterbrochen wird, wenn der erste Berechnungsschritt (5) durchgeführt wird, wobei der Zyklus aufrechterhalten wird, wenn der Mittelwert und die Varianz jeweils kleiner sind als die Schwelle des Mittelwerts und die Schwelle der Varianz.

4. Verfahren nach Anspruch 2 oder 3, wobei der Zyklus des Erfassungsschritts (1, 2) wiederaufgenommen wird, wenn die Dichte kleiner ist als die vorherbestimmte Dichteschwelle.

5. Verfahren nach einem der vorhergehenden Ansprüche, wobei, wenn ein Alarmsignal (A) generiert wird, ein Schritt (9, 10) des Bestimmens des Typs der teilweisen Entladung durchgeführt wird.

6. Verfahren nach Anspruch 1, wobei der Schritt (9, 10) des Bestimmens des Typs der teilweisen Entladung einen Schritt (9) des Suchens der Frequenz umfasst, für die das Verhältnis maximal ist, und, wenn die Frequenz definiert wird, bei der das Verhältnis maximal ist:

   - ein zeitliches Erfassen der von dem inneren UHF-Sensor gelieferten Signale bei der Frequenz durchgeführt wird, bei der das Verhältnis maximal ist, und
   - die zeitlichen Signale, die bei dem Schritt des zeitlichen Erfassens erfasst werden, über eine Referenzspannung ($V_{ref}$) gelegt werden, welche für eine hohe Spannung repräsentativ ist, die in der gasisolierten elektrischen Schaltanlage vorliegt.

7. Verfahren nach einem der vorhergehenden Ansprüche, wobei das Frequenzband, auf dem das Frequenzspektrum der elektromagnetischen Signale, die von dem inneren Sensor detektiert werden, und das Frequenzspektrum der Signale, die von dem äußeren Sensor detektiert werden, berechnet werden, zwischen 100 MHz und 3 GHz liegt.

**EP 3 063 548 B1**

**Claims**

1. Method of detecting partial discharge in a gas insulated electrical substation, wherein at least one UHF sensor internal to said substation detects electromagnetic signals ($S_P$) and at least one UHF sensor external to said substation detects electromagnetic signals ($S_B$), with the method comprising a step of acquisition (1, 2) which measures, over a frequency band, a frequency spectrum of the electromagnetic signals detected by the internal sensor and a frequency spectrum of the signals detected by the external sensor and a first step of calculation (5) which calculates a frequency spectrum of a ratio between the frequency spectrum of the electromagnetic signals detected by the internal sensor and the frequency spectrum of the signals detected by the external sensor, **characterised in that** it comprises:

   - between the step of acquisition (1, 2) and the first step of calculation (5), an intermediate step (3) that calculates an average and/or a variance of the frequency spectrum of the electromagnetic signals detected by the internal sensor, the first step of calculation (5) being implemented only if said average and/or said variance are respectively greater than or equal to a threshold of average and/or to a threshold of variance,
   - a second step of calculation (6) which calculates a density of the frequency spectrum of said ratio which follows the first step of calculation (5),
   - a step of comparing (7) said density with a threshold of predetermined density, and
   - a step of generating an alarm signal (8) when said density is greater than or equal to the predetermined density threshold.

2. Method according to claim 1, wherein the step of acquisition (1, 2) is a cyclical step.

3. Method according to claim 2, wherein the cycle of the step of acquisition (1, 2) is interrupted when the first step (5) of calculation is implemented, said cycle being maintained when said average and said variance are less than respectively the threshold of the average and the threshold of the variance.

4. Method according to claim 2 or 3, wherein the cycle of the step of acquisition (1, 2) resumes when said density is less than the predetermined density threshold.

5. Method according to any one of the preceding claims, wherein, when an alarm signal (A) is generated, a step (9, 10) of determining the type of partial discharge is implemented.

6. Method according to claim 1, wherein the step (9, 10) of determining the type of partial discharge comprises a frequency search step (9) for which said ratio is maximum and, when the frequency at which said ratio is maximum is identified:

   - a temporal acquisition of the signals delivered by the internal UHF sensor is implemented at the frequency at which said ratio is maximum, and
   - the temporal signals acquired at the step of temporal acquisition are superimposed with a reference voltage ($V_{ref}$) that represents a high voltage present in the gas insulated electrical substation.

7. Method according to any one of the preceding claims, wherein the frequency band whereon the frequency spectrum of the electromagnetic signals detected by the internal sensor and the frequency spectrum of the signals detected by the external sensor are calculated is between 100MHz and 3GHz.

9

FIG. 1

FIG. 2a

FIG. 2b

FIG. 2c

FIG. 3

FIG. 4

FIG. 5a

FIG. 5b

FIG. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2977322

**Littérature non-brevet citée dans la description**

- *Procédé et dispositif de contrôle d'un poste électrique haute tension au gaz,* 30 Juin 2011